# EUROPEAN PATENT APPLICATION

(11) **EP 3 525 242 A1**
(43) Date of publication of application: **14.08.2019**
(21) Application number: 17905902.7
(22) Date of filing: 20.12.2017
(51) Int. Cl.: H01L 31/0224

(54) **LIGHT TRANSMITTING SOLAR CELL AND PREPARATION METHOD THEREOF**

(30) Priority: 14.12.2017 CN 201711340704
(71) Applicant: Beijing Apollo Ding Rong Solar Technology Co. Ltd., Beijing 100176 (CN)
(72) Inventor: ZHANG, Xueliang, Beijing 100176 (CN); LIN, Junrong, Beijing 100176 (CN); QI, Weibin, Beijing 100176 (CN); LI, Xinyu, Beijing 100176 (CN); WANG, Hong, Beijing 100176 (CN)
(74) Representative: Roman, Alexis
(86) International application number: PCT/CN2017/117413
(87) International publication number: WO 2019/114009

(57) **Abstract**

The present disclosure discloses a light-transmitting solar cell and a preparation method thereof. The light-transmitting solar cell includes: a substrate; a plurality of first electrodes; a plurality of light absorbing modules, each of the light absorbing modules corresponding to each of the first electrodes one to one, and a first terminal of the first electrode corresponding to a first terminal of each of the light absorbing modules extending out by a preset length to form a conductively connected terminal; the light absorbing module coating an area of the corresponding first electrode except for the conductively connected terminal; and a plurality of light-transmitting second electrodes arranged on the light absorbing modules at intervals and filled between two adjacent first electrodes and between two adjacent light absorbing modules, each of the second electrodes corresponding to each of the first electrodes one to one. By arranging a plurality of first electrodes, a plurality of light absorbing modules and a plurality of second electrodes on the substrate at intervals, and by filling a light-transmitting second electrode into a divided region between the first electrode and the light absorbing module, light rays may pass through the second electrode of the divided region and the substrate, such that the solar cell has the function of light transmission.

## Description

### TECHNICAL FIELD

The present disclosure relates to the field of photovoltaic cell processing, and more particularly, to a light-transmitting solar cell and a preparation method thereof.

### BACKGROUND

CIGS (short for solar thin-film cell CuInxGa(1-x)Se₂, mainly made up of Cu, In, Ga and Se) photovoltaic cell is high in power generation efficiency, mature in fabrication technology, and thus is one of mainstream photovoltaic cells at present. In the CIGS photovoltaic cell, glass is mainly used as a substrate, and on the glass there are plated with a molybdenum (Mo) layer, a CIGS layer, a cadmium sulfide (CdS) layer, and a transparent conductive oxide (TCO) layer, wherein the TCO layer is a light receiving face.

Currently, the photovoltaic cells not only are used in power stations for power generation, but also are demanded for making a glass curtain wall. When making the glass curtain wall, not only requirements for power generation need to be taken into account, but also requirements for aesthetic sense and light transmission need to be taken into account.

The existing CIGS photovoltaic cells generally are black, are impossible for light transmission, and thus cannot satisfy actual demands.

### SUMMARY

An objective of the present disclosure is to provide a light-transmitting solar cell and a preparation method thereof to solve the problems in the prior art, to enable the cell to transmit light, and to satisfy actual demands.

In one aspect, the present disclosure provides a light-transmitting solar cell, which includes:
a substrate;
a plurality of first electrodes arranged on the substrate at intervals;
a plurality of light absorbing modules arranged on the first electrodes at intervals, each of the light absorbing modules corresponding to each of the first electrodes one to one, and a first terminal of the first electrode corresponding to a first terminal of each of the light absorbing modules extending out by a preset length to form a conductively connected terminal; the light absorbing module coating an area of the corresponding first electrode except for the conductively connected terminal; and a plurality of light-transmitting second electrodes arranged on the light absorbing modules at intervals and filled between two adjacent first electrodes and between two adjacent light absorbing modules, each of the second electrodes corresponding to each of the first electrodes one to one.

Preferably, the preset length is greater than 0 µm and less than or equal to 100µm.

Preferably, an interval of two adjacent second electrodes is positioned above the first electrode.

Preferably, the interval of the two adjacent second electrodes extends downward, passes through the light absorbing module above the first electrode and extends to an upper surface of the first electrode.

Preferably, an opening between two adjacent light absorbing modules is partially overlapped with an opening between two adjacent first electrodes.

Preferably, the substrate includes substrate glass, the first electrode includes a molybdenum layer, the light absorbing module includes a copper indium gallium selenium (CIGS) layer and a cadmium sulfide layer, and the second electrode includes a transparent conductive oxide (TCO) layer.

In another aspect, the present disclosure also provides a method for preparing a light-transmitting solar cell, which includes:
forming a first electrode layer on a substrate;
dividing the first electrode layer into a plurality of first electrodes distributed at intervals;
forming a light absorbing layer on the first electrode;
dividing the light absorbing layer into a plurality of light absorbing modules corresponding to each of the first electrodes one to one, and the formed light absorbing module coating an area of the corresponding first electrode except for a conductively connected terminal;
forming a light-transmitting second electrode layer on the light absorbing module, between two adjacent first electrodes and between two adjacent light absorbing modules; and
dividing the second electrode layer into a plurality of spaced second electrodes.

Preferably, dividing the light absorbing layer into a plurality of light absorbing modules corresponding to each of the first electrodes one to one, and the formed light absorbing module coating an area of the corresponding first electrode except for a conductively connected terminal specifically include:
dividing the light absorbing layer at a location corresponding to an interval between the first electrodes, and a portion of the divided light absorbing layer corresponding to each of the first electrodes including: a first portion positioned on the corresponding first electrode and a second portion coating a first side of the corresponding first electrode, the first side being a side opposite to a side where the first electrode is provided with the conductively connected terminal; and
removing the light absorbing layer on the conductively connected terminal of each first electrode to form the light absorbing module.

Preferably, the division is implemented by etching using laser or an etching knife.

Preferably, the substrate includes substrate glass, the first electrode includes a molybdenum layer, the light absorbing module includes a copper indium gallium selenium (CIGS) layer and a cadmium sulfide layer, and the second electrode includes a transparent conductive oxide (TCO) layer.

According to the light-transmitting solar cell and the preparation method thereof provided by the present disclosure, by arranging a plurality of first electrodes, a plurality of light absorbing modules and a plurality of second electrodes on the substrate at intervals, and by filling a light-transmitting second electrode into a divided region between the first electrode and the light absorbing module, light rays may pass through the second electrode of the divided region and the substrate, such that the solar cell has the function of light transmission, and the actual demands for light transmission and so on may be satisfied.

### BRIEF DESCRIPTION OF THE DRAWING

FIG. 1 is a schematic structural diagram of a preparation process of a light-transmitting solar cell according to an embodiment of the present disclosure;
FIG. 2 is a schematic structural diagram of a preparation process of a light-transmitting solar cell according to an embodiment of the present disclosure;
FIG. 3 is a schematic structural diagram of a preparation process of a light-transmitting solar cell according to an embodiment of the present disclosure;
FIG. 4 is a schematic structural diagram of a preparation process of a light-transmitting solar cell according to an embodiment of the present disclosure;
FIG. 5 is a schematic structural diagram of a preparation process of a light-transmitting solar cell according to an embodiment of the present disclosure;
FIG. 6 is a schematic structural diagram of a preparation process of a light-transmitting solar cell according to an embodiment of the present disclosure;
FIG. 7 is a schematic structural diagram of a light-transmitting solar cell according to an embodiment of the present disclosure; and
FIG. 8 is a schematic flow chart of a method for preparing a light-transmitting solar cell according to an embodiment of the present disclosure.

Reference numbers in the attached drawings:
1-substrate, 2-first electrode, 21-first terminal, 22-second terminal, 23-conductively connected terminal, 3-light absorbing module, 4-second electrode, 5-first electrode layer, 6-light absorbing layer, and 7-second electrode layer.

### DETAILED DESCRIPTION OF THE EMBODIMENTS

The embodiments of the disclosure will be described in detail as below. Examples of the embodiments are as shown in drawings, in which same or similar reference numbers always represent same or similar elements or elements with same or similar functions. The embodiments described with reference to the drawings are exemplary, just used for explaining the disclosure, not for limiting the disclosure.

### Embodiment I

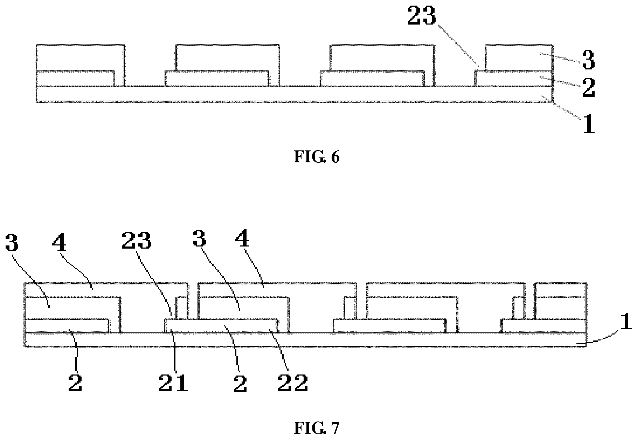

As shown in FIG. 7, an embodiment of the present disclosure provides a light-transmitting solar cell, which includes: a substrate 1;
a plurality of first electrodes 2 arranged on the substrate 1 at intervals;
a plurality of light absorbing modules 3 arranged on the first electrodes 2 at intervals, wherein each of the light absorbing modules 3 corresponds to each of the first electrodes 2 one to one, and a first terminal of the first electrode 2 corresponding to a first terminal of each of the light absorbing modules 3 extends out by a preset length to form a conductively connected terminal 23; the light absorbing module 3 coating an area of the corresponding first electrode 2 except for the conductively connected terminal 23; and a plurality of light-transmitting second electrodes 4 arranged on the light absorbing modules 3 at intervals and filled between two adjacent first electrodes 2 and between two adjacent light absorbing modules 3, each of the second electrodes 4 corresponding to each of the first electrodes 2 one to one.

As shown in FIG. 7, the first terminal 21 is the left edge of the first electrode 2, whereas the second terminal 22 is the right edge of the first electrode 2. The conductively connected terminal 23 is arranged above the first terminal 21 of the first electrode 2, that is, the light absorbing modules 3 above the left edge of the first electrode 2 are completely removed to form the conductively connected terminal 23. Preferably, the preset length is greater than 0 µm and less than or equal to 100µm. The second electrode 4 is filled into the conductively connected terminal 23, the first electrode 2 below and the second electrode 4 on the left come into contact to be conductive by means of the conductively connected terminal 23, and so on, such that power generation regions (including the first electrode 2 and the second electrode 4) are connected in series. The light absorbing module 3 coats the second terminal 22 of the first electrode 2, that is, the right edge and the upper surface of the first electrode 2, such that the light absorbing module 3 insulates the first electrode 2 from the second electrode 4 to prevent from producing a short circuit due to a fact that the first electrode 2 and the second electrode 4 come into contact to be conductive.

Preferably, an opening between two adjacent light absorbing modules 3 is partially overlapped with an opening between two adjacent first electrodes 2. The opening is an opening at the interval, and the two openings are partially overlapped with the purpose of allowing each of the first electrodes 2 to be corresponding to the light absorbing module 3 one to one. The power generation regions are connected in series, whereas a distance from the right edge of the light absorbing module 3 to the left edge of the first electrode 2 on the right of the light absorbing module 3 generally is set to be 5mm, and those skilled in the art may realize that the distance is not specifically limited but is flexibly set according to actual needs.

In the light-transmitting solar cell provided by the present disclosure, by arranging a plurality of first electrodes 2, a plurality of light absorbing modules 3 and a plurality of second electrodes 4 on the substrate 1 at intervals, and by filling a light-transmitting second electrode 4 into a divided region between the first electrode 2 and the light absorbing module 3, light rays may pass through the second electrode 4 of the divided region and the substrate 1, that is, a light transmitting region is formed between two adjacent first electrodes 2, between two adjacent light absorbing modules 3 and at the conductively connected terminal 23, such that the solar cell has the function of light transmission, and the actual demands for light transmission and so on may be satisfied.

Preferably, an interval of two adjacent second electrodes 4 is positioned above the first electrode 2. Preferably, the interval of the two adjacent second electrodes 4 extends downward, passes through the light absorbing module 3 above the first electrode 2 and extends to an upper surface of the first electrode 2. By way of such an arrangement, it is ensured that the second electrodes 4 are insulated, meanwhile, in consideration of actual operation convenience, the interval may be formed by completely removing the light absorbing modules 3 above a part of the first electrodes 2 and the second electrodes 4.

Preferably, the substrate 1 includes substrate glass, the first electrode 2 includes a molybdenum layer, the light absorbing module 3 includes a copper indium gallium selenium (CIGS) layer and a cadmium sulfide layer, and the second electrode 4 includes a transparent conductive oxide (TCO) layer.

### Embodiment II

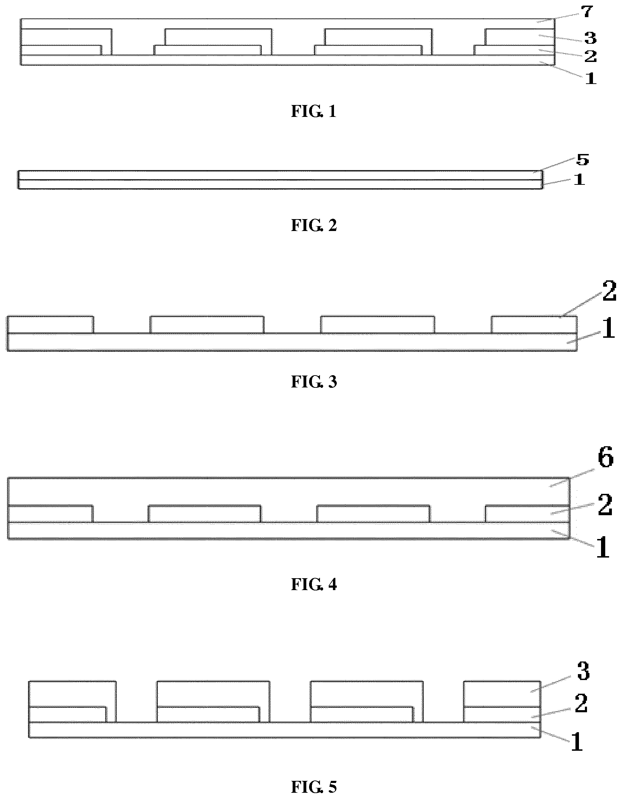

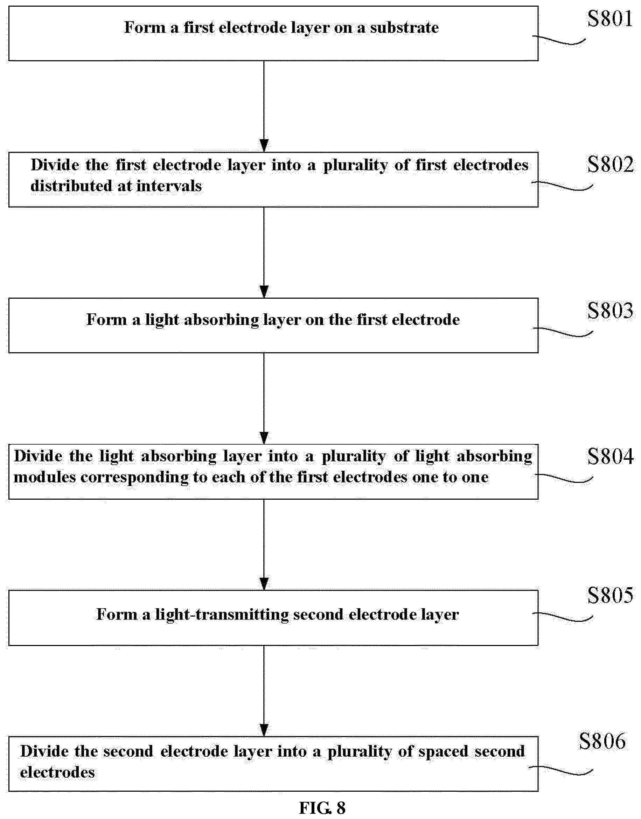

As shown in FIG. 8, or referring to FIG. 1-FIG. 7, another embodiment of the present disclosure also provides a method for preparing a light-transmitting solar cell, which includes:
Step S801: forming a first electrode layer 5 on a substrate 1;
Step S802: dividing the first electrode layer 5 into a plurality of first electrodes 2 distributed at intervals;
Step S803: forming a light absorbing layer 6 on the first electrode 2, wherein the light absorbing layer 6 may be formed by way of film coating;
Step S804: dividing the light absorbing layer 6 into a plurality of light absorbing modules 3 corresponding to each of the first electrodes 2 one to one, and the formed light absorbing module 3 coating an area of the corresponding first electrode 2 except for a conductively connected terminal 23;
Step S805: forming a light-transmitting second electrode layer 7 on the light absorbing module 3, between two adjacent first electrodes 2 and between two adjacent light absorbing modules 3; and
Step S806: dividing the second electrode layer 7 into a plurality of spaced second electrodes 4.

Preferably, Step S804 of dividing the light absorbing layer 6 into a plurality of light absorbing modules 3 corresponding to each of the first electrodes 2 one to one, and the formed light absorbing module 3 coating an area of the corresponding first electrode 2 except for a conductively connected terminal 23 specifically include:
dividing the light absorbing layer 6 at a location corresponding to an interval between the first electrodes 2, and a portion of the divided light absorbing layer 6 corresponding to each of the first electrodes 2 including: a first portion positioned on the corresponding first electrode 2 and a second portion coating a first side of the corresponding first electrode 2, the first side being a side opposite to a side where the first electrode 2 is provided with the conductively connected terminal 23; and
removing the light absorbing layer 6 on the conductively connected terminal 23 of each first electrode 2 to form the light absorbing module 3.

Preferably, the division is implemented by etching using laser or an etching knife. Etching using an etching knife generally refers to removing each film layer by means of mechanical tools such as a scraper.

Preferably, the substrate 1 includes substrate glass, the first electrode 2 includes a molybdenum layer, the light absorbing module 3 includes a copper indium gallium selenium (CIGS) thin-film solar cell layer and a cadmium sulfide layer, and the second electrode 4 includes a transparent conductive oxide (TCO) layer. Preferably, the second electrode 4 also may be an indium tin oxide (ITO) semiconductor transparent conductive film layer.

A light transmitting region is formed by removing the portion between two first electrodes 2 and removing the portion between two light absorbing modules 3 (namely, by dividing) to make preparations for filling the second electrode 4. Removing the light absorbing module 3 above the first terminal 21 of each first electrode 2 is in order to form the conductively connected terminal 23, namely, to form the molybdenum layer serving as a connection point for series connection between the power generation regions. The first side of the first electrode 2 is the upper portion and the right edge of the location where the second terminal 22 of the first electrode 2 is. The TCO layer is selected and used as the second electrode 4 due to its better light permeability and electrical conductivity.

The solar cell prepared by using the method for preparing a light-transmitting solar cell provided by the present disclosure has the function of light transmission, and thus satisfies actual demands for light transmission and power generation or the like, and is simple and convenient in technology, and is lower in cost.

The above embodiments as shown in the drawings illustrate the structure, the features and the effects of the light-transmitting solar cell in detail, and the above embodiments are merely preferred embodiments of the present disclosure. However, the present disclosure does not limit the scope of implementation according to what is shown in the figures. Any modifications made in accordance with the conception of the present disclosure or equivalent embodiments revised as equivalent changes shall fall within the scope of protection of the present disclosure as long as they are within the spirit of the specification and the spirit covered by the drawings.

## Claims

1. A light-transmitting solar cell, comprising:
a substrate (1);
a plurality of first electrodes (2) arranged on the substrate (1) at intervals;
a plurality of light absorbing modules (3) arranged on the first electrodes (2) at intervals, each of the light absorbing modules (3) corresponding to each of the first electrodes (2) one to one, and a first terminal of the first electrode (2) corresponding to a first terminal of each of the light absorbing modules (3) extending out by a preset length to form a conductively connected terminal (23); the light absorbing module (3) coating an area of the corresponding first electrode (2) except for the conductively connected terminal (23); and
a plurality of light-transmitting second electrodes (4) arranged on the light absorbing modules (3) at intervals and filled between two adjacent first electrodes (2) and between two adjacent light absorbing modules (3), each of the second electrodes (4) corresponding to each of the first electrodes (2) one to one.

2. The light-transmitting solar cell according to claim 1, wherein the preset length is greater than 0 µm and less than or equal to 100µm.

3. The light-transmitting solar cell according to claim 1, wherein an interval of two adjacent second electrodes (4) is positioned above the first electrode (2).

4. The light-transmitting solar cell according to claim 3, wherein the interval of the two adjacent second electrodes (4) extends downward, passes through the light absorbing module (3) above the first electrode (2) and extends to an upper surface of the first electrode (2).

5. The light-transmitting solar cell according to claim 1, wherein an opening between two adjacent light absorbing modules (3) is partially overlapped with an opening between two adjacent first electrodes (2).

6. The light-transmitting solar cell according to claim 1, wherein the substrate (1) comprises substrate glass, the first electrode (2) comprises a molybdenum layer, the light absorbing module (3) comprises a copper indium gallium selenium (CIGS) layer and a cadmium sulfide layer, and the second electrode (4) comprises a transparent conductive oxide (TCO) layer.

7. A method for preparing a light-transmitting solar cell, comprising:
forming a first electrode layer (5) on a substrate (1);
dividing the first electrode layer (5) into a plurality of first electrodes (2) distributed at intervals;
forming a light absorbing layer (6) on the first electrode (2);
dividing the light absorbing layer (6) into a plurality of light absorbing modules (3) corresponding to each of the first electrodes (2) one to one, and the formed light absorbing module coating an area of the corresponding first electrode (2) except for a conductively connected terminal (23);
forming a light-transmitting second electrode layer (7) on the light absorbing module, between two adjacent first electrodes (2) and between two adjacent light absorbing modules (3); and
dividing the second electrode layer (7) into a plurality of spaced second electrodes (4).

8. The preparation method according to claim 7, wherein the dividing the light absorbing layer (6) into a plurality of light absorbing modules (3) corresponding to each of the first electrodes (2) one to one, and the formed light absorbing module coating an area of the corresponding first electrode (2) except for a conductively connected terminal (23) specifically comprise:
dividing the light absorbing layer (6) at a location corresponding to an interval between the first electrodes (2), and a portion of the divided light absorbing layer (6) corresponding to each of the first electrodes (2) comprising: a first portion positioned on the corresponding first electrode (2) and a second portion coating a first side of the corresponding first electrode (2), the first side being a side opposite to a side where the first electrode (2) is provided with the conductively connected terminal (23); and
removing the light absorbing layer (6) on the conductively connected terminal (23) of each first electrode (2) to form the light absorbing module.

9. The preparation method according to claim 7, wherein the division is implemented by etching using laser or an etching knife.

10. The preparation method according to claim 7, wherein the substrate (1) comprises substrate glass, the first electrode (2) comprises a molybdenum layer, the light absorbing module comprises a copper indium gallium selenium (CIGS) layer and a cadmium sulfide layer, and the second electrode comprises a transparent conductive oxide (TCO) layer.
